(19) Europäisches Patentamt / European Patent Office / Office européen des brevets

(11) **EP 4 383 577 B1**

(12) **EUROPEAN PATENT SPECIFICATION**

(45) Date of publication and mention
of the grant of the patent:
**28.01.2026 Bulletin 2026/05**

(21) Application number: **22211968.7**

(22) Date of filing: **07.12.2022**

(51) International Patent Classification (IPC):
*H04B 1/04* (2006.01)       *H03F 1/02* (2006.01)
*H04B 17/11* (2015.01)      *H03F 1/32* (2006.01)

(52) Cooperative Patent Classification (CPC):
**H04B 1/0475; H03F 1/3247; H03F 3/189;**
**H03F 3/24; H04B 17/0085**

(54) **A METHOD AND APPARATUS FOR LINEARIZING A TRANSMISSION AMPLIFIER OF A TRANSMITTER WITHIN A WIRELESS NETWORK**

VERFAHREN UND VORRICHTUNG ZUR LINEARISIERUNG EINES SENDEVERSTÄRKERS EINES SENDERS IN EINEM DRAHTLOSEN NETZWERK

PROCÉDÉ ET APPAREIL DE LINÉARISATION D'UN AMPLIFICATEUR DE TRANSMISSION D'UN ÉMETTEUR DANS UN RÉSEAU SANS FIL

(84) Designated Contracting States:
**AL AT BE BG CY CZ DE DK EE ES FI FR GB GR HR HU IS IT LT LU LV MC ME MK MT NL NO PL PT RO RS SE SI SK SM TR**

(43) Date of publication of application:
**12.06.2024 Bulletin 2024/24**

(73) Proprietor: **Rohde & Schwarz GmbH & Co. KG**
**81671 München (DE)**

(72) Inventor: **VALTEN, Thomas**
**82008 Unterhaching (DE)**

(74) Representative: **Novagraaf Group**
**Chemin de l'Echo 3**
**1213 Onex / Geneva (CH)**

(56) References cited:
**EP-A1- 2 542 011        WO-A1-2017/030935**
**WO-A2-2007/044957      WO-A2-2008/027295**
**US-A1- 2015 023 451**

## Description

The invention relates to a method and an apparatus for linearizing a transmission amplifier of a transmitter within a wireless network such as a telecommunication network or within a decentralized ad hoc network.

In wireless networks, complex modulation processes can be applied. The resulting transmission signal may comprise a high crest factor where the signal envelope of the transmission signal comprises strong oscillations. In case that such a signal is supplied to a power amplifier, intermodulation products of third order are generated at the output of the power amplifier due to nonlinearities. The nonlinearity is caused by the AM/AM distortion of the transmission characteristic caused by saturation of the power amplifiers. The distortion can be reduced by providing bias currents to the transistors of the power amplifier, however, this reduces the efficiency of the transmission power stage.

A conventional way to increase the efficiency of a transmission power stage is a reduction of the bias currents and to perform a pre-distortion of the input signal of the respective power amplifier to compensate for the compression of the respective power amplifier. Pre-distortion is achieved by multiplication of a complex transmission signal with an inverse characteristic of the respective transmission amplifier. Accordingly, to determine the required inverse characteristic of the transmission amplifier in conventional systems, the transmission signal is coupled to an additional reception signal path where it is demodulated and compared with an ideal undistorted transmission signal. However, this conventional way to determine the inverse characteristics requires the provision of additional hardware within the respective apparatus. This increases the complexity of the circuit, the power consumption and the size of the apparatus. WO2007044957 describes a method and a system for calculating closed loop pre-distortion coefficients at a location for a remote terminal. WO2017030935 describes a digital dynamic bias circuit in an RF transmitter. The calculation of the pre-distortion polynomial coefficients can be performed locally in the user terminal or in a remote gateway.

Accordingly, it is an object of the present invention to provide a method and apparatus which compensate for unwanted distortions of a transmission amplifier while requiring no additional hardware.

This object is achieved by a method comprising the features of claim 1, and an apparatus comprising the features of claim 21.

Further embodiments and aspects are presented in the remaining dependent claims.

In the following, possible embodiments of the different aspects of the present invention are described in more detail with reference to the enclosed figures.

Fig. 1　　shows a flowchart for illustrating a possible exemplary embodiment of a method for linearizing a transmission amplifier of a transmitter within a wireless network according to a first aspect of the present invention;

Fig. 2　　shows a block diagram for illustrating the communication between two apparatuses according to the second aspect of the present invention using the method for linearizing a transmission amplifier of a transmitter within a wireless network according to the first aspect of the present invention;

Fig. 3　　shows a schematic diagram for illustrating a possible exemplary embodiment of a wireless network implementing a method for linearizing a transmission amplifier of a transmitter within a wireless network as illustrated in Fig. 1;

Fig. 4　　illustrates a possible exemplary implementation of a real part of a test signal as employed by the method and apparatus according to the present invention;

Fig. 5　　illustrates a possible exemplary implementation an imaginary part of the test signal as employed by the method and apparatus according to the present invention;

Fig. 6　　shows a diagram for illustrating a received test signal with and without AM/AM compression used to provide a multiplied compensation characteristic;

Fig. 7　　illustrates a real part of a test signal with root Nyquist pulse shaping;

Fig. 8　　illustrates a received test signal without AM/AM distortion and with AM/AM distortion for a real part of a test signal with root Nyquist pulse shaping;

Fig. 9　　shows a power spectrum for illustrating the effects of AM/AM distortion in a transmission characteristic as compared to an ideal power amplifier characteristic;

Fig. 10        shows a power spectrum for illustrating a successful linearizing of a power amplifier by using the method according to the present invention;

Figs. 11, 12, 13    illustrate typical channel responses with and without multi-path propagation for different signal-to-noise ratios;

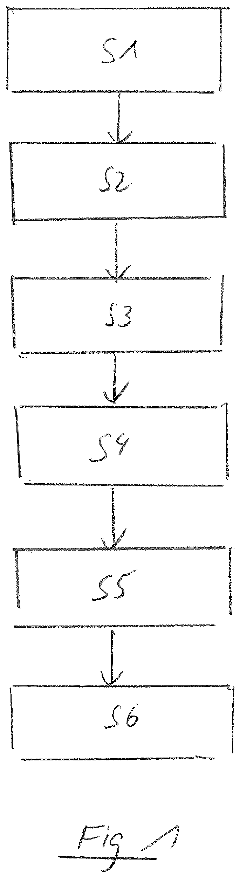

Fig. 1 shows a flowchart of a possible embodiment of a method for linearizing a transmission amplifier of a transmitter within a wireless network according to a first aspect of the present invention.

In the illustrated embodiment of Fig.1, the method comprises six main steps.

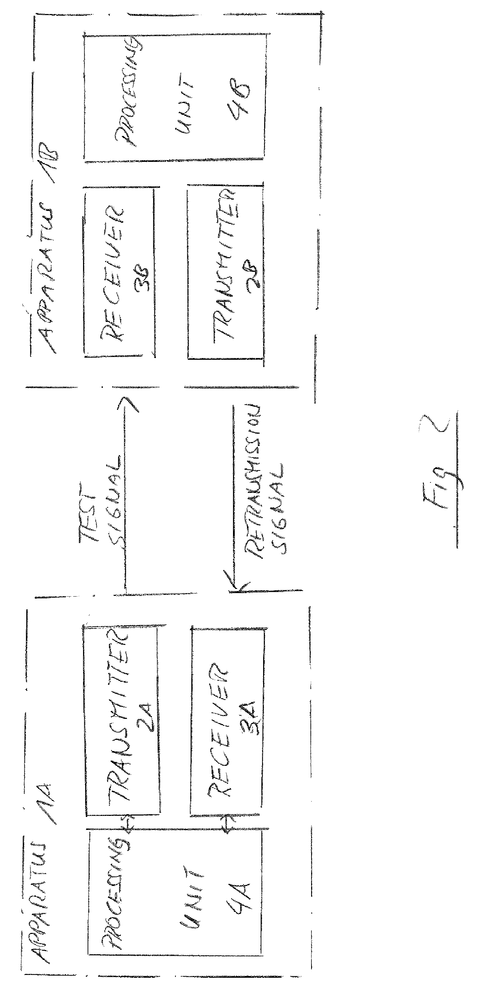

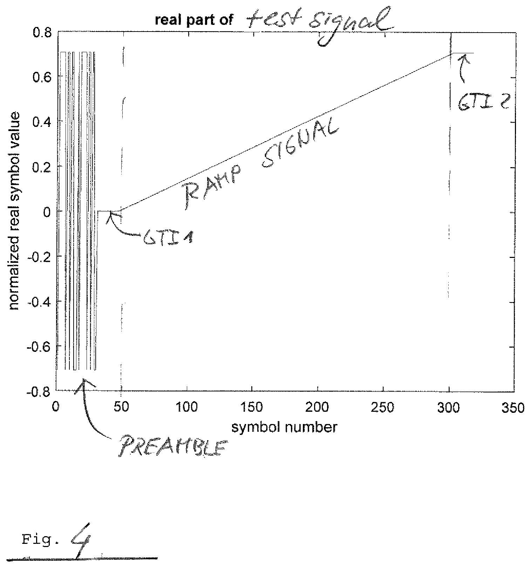

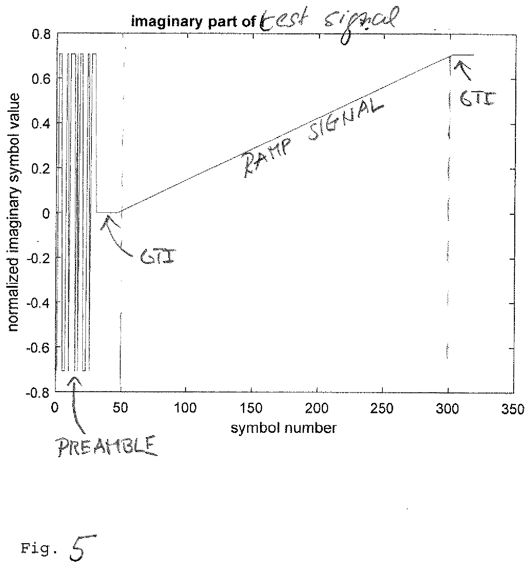

In a first step S1, a test signal is transmitted by a transmitter 2A of a first apparatus 1A of the wireless network as also illustrated in Fig.2. The transmitted test signal comprises a preamble and a ramp signal as also illustrated in Figs. 4, 5. The preamble of the signal can identify the respective signal a being a test signal.

The test signal transmitting first apparatus 1A of the wireless network may also be simply referred to as the transmitter. The test signal receiving second apparatus 1B of the wireless network may also be simply referred to as the receiver.

The transmitted test signal is received in step S2 by at least one receiver 3B of a second apparatus 1B of the wireless network. The apparatus can form part of a mobile or immobile network node of the wireless network.

In a further step S3, the transmitting apparatus of the transmitted test signal, i.e. the test signal transmitting first apparatus 1A, is identified by the test signal receiving second apparatus 1B of the wireless network on the basis of the preamble of the test signal received by the receiver 3B of the second apparatus 1B.

In a further step S4, a pre-distortion characteristic of the transmission amplifier of the transmitter of the first apparatus 1A is calculated by a processor 4B of the second apparatus 1B connected to the receiver 3B of the second apparatus 1B on the basis of the distorted ramp signal of the test signal received by the receiver 3B of the second apparatus 1B.

In a further step S5, a retransmission signal is transmitted by a transmitter 2B of the test signal receiving second apparatus 1B back to the identified test signal transmitting first apparatus 1A within the wireless network. The retransmission signal comprises a preamble and the calculated pre-distortion characteristic of the transmission amplifier of the transmitter 2A of the identified test signal transmitting first apparatus 1A. The preamble of the retransmission signal can identify the respective signal as being a retransmission signal. If a received signal is recognized as being a retransmission signal addressed to the first apparatus 1A the pre-distortion characteristic carried within the received retransmission signal can be extracted automatically and then stored at least temporarily in a table of a local data memory of the first apparatus 1A to be employed by a pre-distortion unit of the first apparatus 1A for pre-distortion of a signal supplied to a transmission amplifier of the transmitter 2A of the first apparatus 1A when sending or broadcasting a signal in the wireless network.

In a final step S6, the transmission amplifier of the transmitter 2A of the test signal transmitting first apparatus 1A is linearized automatically on the basis of the pre-distortion characteristic included and transported in the retransmission signal received by the receiver 3A of the first apparatus 1A of the wireless network from the transmitter 2B of the test signal receiving second apparatus 1B of the wireless network and stored in the local data memory of the first apparatus 1A .

The preamble of the test signal transmitted by the transmitter in step S1 comprises a preamble and a ramp signal. Fig. 4 illustrates the real part of the transmitted test signal. Fig. 5 illustrates an imaginary part of the transmitted test signal. Accordingly, the transmitted test signal is a complex signal having a real signal part and an imaginary signal part. The transmitted test signal comprises complex symbols as shown in Figs. 4, 5. The numbers of the symbols of the test signal may vary depending on the use case. As can be seen in Figs. 4, 5, the test signal comprises at its beginning a preamble which can be used to identify a transmitter of a transmitting first apparatus 1A by a receiver or receiving apparatus 1B receiving the transmitted test signal. The preamble can also be used for calculating a channel response, in particular a channel impulse response h, of a transmission channel between the transmitter 2A and the receiver 3B as shown in Fig.2. The test signal comprises a ramp signal as shown in Figs. 4, 5. In the illustrated embodiment of Figs. 4, 5, the ramp signal comprises a linear increasing signal comprising a predefined number of symbols k. In the illustrated embodiment, the symbols k comprise values between an initial value of zero and a final value of one divided by the square root of two (1/sqrt(2)). On both sides of the ramp signal, guard time intervals GTI can be provided in a possible implementation. The provision of guard time intervals GTI allows transmission filters and reception filters to swing in without influencing the ramp signal. The first guard time interval GTI1 comprises identical symbols k having a value of zero as illustrated in Figs. 4, 5. The second guard time interval GTI2 comprises identical symbols k having a value of one divided by the square root of two (1/sqrt(2)) as illustrated in Figs. 4, 5.

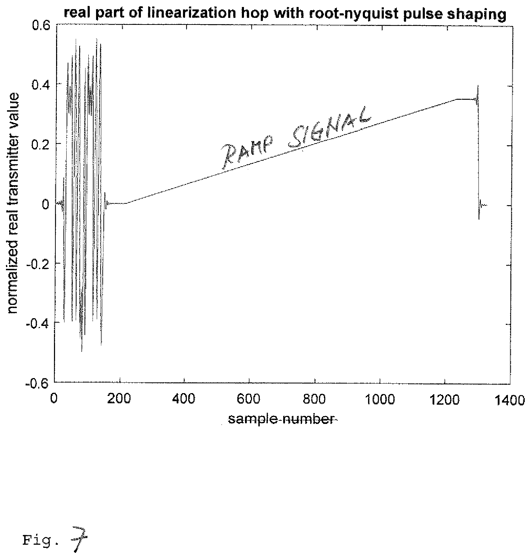

In a possible embodiment, the test signal is supplied to a root Nyquist filter for transmission. The root Nyquist filter can comprise a predefined oversampling rate. The resulting transmission signal is illustrated in Fig. 7. As can be seen in Fig. 7, the transmission filter swings in at the beginning and at the end of the guard time. The ramp signal within the received test signal forms the basis for determining the pre-distortion characteristic.

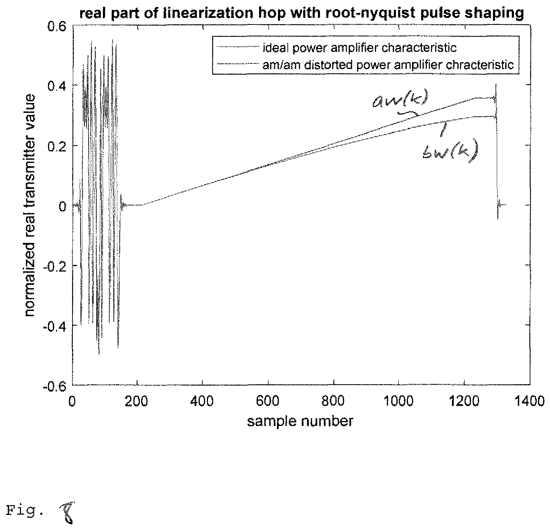

In a possible embodiment, the transmitter or transmitting node 1A of the transmitted test signal can be identified by a receiver 3B of a receiving node or receiving apparatus 1 on the basis of a transmitter identifier extracted from the received test signal. After having identified the transmitter or transmitting node 1A, the pre-distortion characteristic of the transmission amplifier of the identified transmitter 2A is calculated in step S4 by a processor or processing unit 4B of the receiving second apparatus 1B having received the test signal from the transmitting first apparatus 1A. This calculation is performed on the basis of the distorted ramp signal bw(k) of the test signal received by the receiver 3B of the receiving second apparatus 1B as illustrated in Fig. 8. The values dw(k) of the pre-distortion characteristic are calculated by the processing unit 4B of the receiving second apparatus 1B of the wireless network in response to values aw(k) of a non-distorted linear ramp signal and depending on values bw(k) of the distorted ramp signal transported within the test signal and received by the receiver 3B of the second apparatus 1B of the wireless network. In a possible embodiment, the values of the non-distorted linear ramp signal aw(k) can be read from a data memory of the receiving second apparatus 1B of the wireless network. In a possible embodiment, the complex distorted ramp signal having the values bw(k) can be cut on the receiving side from the received sampling values. To avoid scaling problems, the values of the distorted ramp signal bw(k) can be normalized to a maximum value. This can for instance be achieved by division of all complex values by the maximum absolute value of bw(k) (max abs(bw(k))). To achieve a desired resolution of the pre-distortion characteristic, the received distorted ramp signal can be interpolated by a suitable interpolation filter to achieve the required number of sampling values. This also provides an additional suppression of unwanted noise. The linear ramp signal sample values are cut out including both guard time intervals GTI1, GTI2 to guarantee the swinging in of the interpolation filter. On the basis of the known ideal ramp signal values aw(k), it is possible for a processor 4B connected to the receiver 3B to calculate values of the pre-distortion characteristics dw(k). For this purpose, the absolute values of the distorted ramp signal bw(k) and of the known ideal non-distorted linear ramp signal aw(k) are divided. In order that the division does not cause numerical problems for small input values, this division is only performed starting from a predefined threshold value S and the corresponding values of the pre-distortion characteristic are set to a value of one (dw(k)=1). This is admissible since the power amplifiers work at small inputs in a linear manner and do not require any pre-distortion. If the symbol number k is larger than the predefined threshold value S, absolute values abs(bw(k)) of the symbols k of the distorted ramp signal bw(k) are divided by absolute values abs(aw(k)) of the symbols k of the linear non-distorted ramp signal aw(k) to calculate the values dw(k) of the pre-distortion characteristic.

The pre-distortion characteristic calculated in step S4 is transmitted in step S5 within a retransmission signal from a transmitter 2B of the test signal receiving second apparatus 1B of the wireless network back to the identified test signal transmitting first apparatus 1A. Using the retransmitted pre-distortion characteristic, the transmission amplifier of the transmitter 2A of the node 1A having sent the test signals can be linearized on the basis of the received pre-distortion characteristic stored in a data memory of the node 1A. For linearizing the transmission amplifier of the transmitter 2A, each sample value s(k) of a complex input signal supplied to the transmission amplifier of the transmitter 2A is multiplied with a value dw(n) of the re-transmitted and stored pre-distortion characteristic. The index n of the value of the pre-distortion characteristic used for multiplication is determined in a possible embodiment depending on the absolute value of the respective sample value s(k) of the complex input signal supplied to the transmission amplifier of the transmitter 2A and depending on a scaling factor P.

$$n = round(abs(s(k) \cdot P))$$

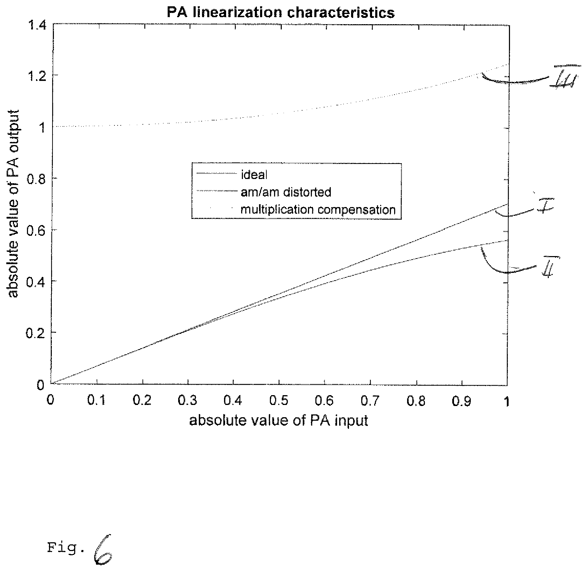

Fig. 6 illustrates the linearization of the transmission amplifier of a transmitter performed in step S6 of the method according to the first aspect of the present invention. Curve I represents the ideal linear increasing ramp signal. Curve II illustrates the received nonlinear characteristic. Curve III represents the pre-distortion characteristic provided by multiplication.

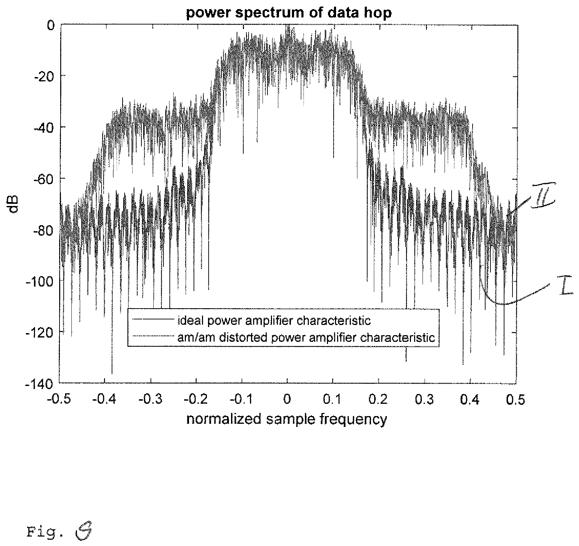

Fig. 9 illustrates the effects of an AM/AM distortion of the transmitter characteristic. The spectrum I illustrates the behavior of a power amplifier without distortion, i.e. an ideal power amplifier characteristic. The spectrum II of Fig. 9 illustrates a power amplifier having AM/AM distortion, i.e. an AM/AM distorted power amplifier characteristic. Fig. 9 shows the intermodulation products at the shoulders of the illustrated spectrum II.

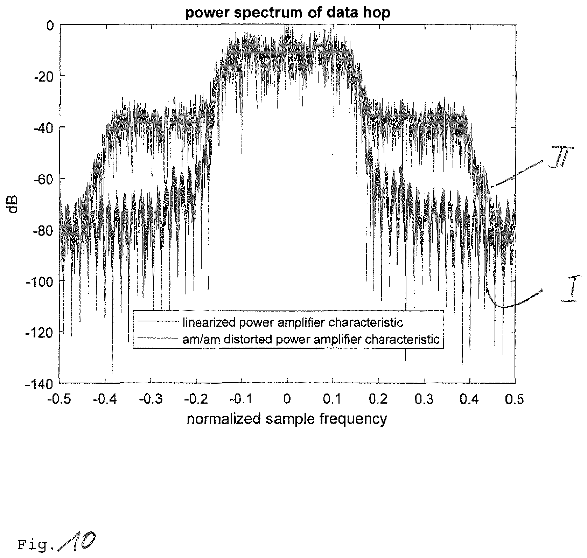

A successful linearization of the transmission amplifier of a transmitter is illustrated in Fig. 10. The spectrum II illustrates a transmission amplifier having AM/AM distortion. The power spectrum I of Fig. 10 illustrates a power amplifier where the input signal supplied to the power amplifier is multiplied with a pre-distortion characteristic dw(k).

To guarantee that the linearization of the transmission amplifier is performed successfully, it is necessary that the test signal is received by the receiver without disturbances. For this reason, the determination of at least one metric M indicating the quality of the received test signal is necessary. In a possible embodiment, the at least one metric representing the quality of the test signal received in step S2 is determined on the basis of a calculated channel impulse response h of the test signal received by the receiver of the wireless network.

In a possible implementation, two metrics M1, M2 can be used. The first metric M1 represents the quality of the test signal received by the receiver of the wireless network with respect to multi-path signal propagation. A second metric M2 represents the quality of the test signal received by the receiver of the wireless network with respect to signal-to-noise ratio SNR.

In a possible embodiment, the pre-distortion characteristic of the transmission amplifier of the identified transmitter is calculated by the at least one receiver of the wireless network on the basis of the distorted ramp signal of the test signal received by the receiver if both determined metrics M1, M2 indicate a sufficient quality of the test signal received by the receiver of the wireless network. If at least one of the determined metrics M1, M2 indicate that the quality of the test signal is not sufficient, the received test signal is not taken into account when calculating the pre-distortion characteristic of the transmission amplifier.

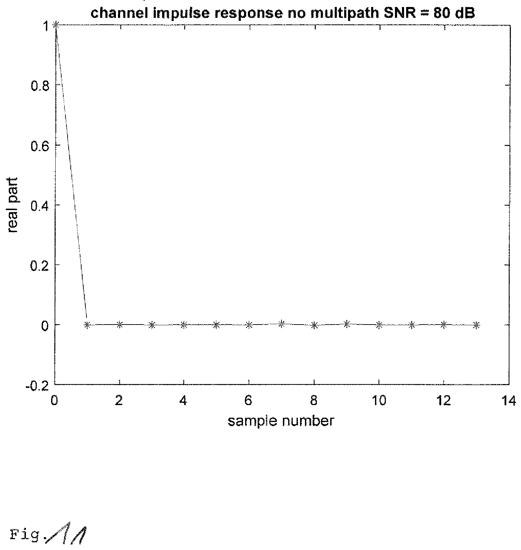

Figs. 11, 12, 13 illustrate typical channel impulse responses h of a transmission channel between a transmitter and a receiver of a wireless network. Fig. 11 illustrates a channel impulse response h of the transmission channel without multi-path signal propagation and a high signal-to-noise ratio SNR of 80 dB. The resulting metrics allow to calculate a pre-distortion characteristic. As can be seen in Fig. 11, besides the main maximum, no other subordinate maxima are provided which might be caused by multi-path signal propagation. The calculation of the signal-to-noise ratio SNR can be performed such that the power of the main maximum is divided by a sum of the power of all other sample values of the channel impulse response h.

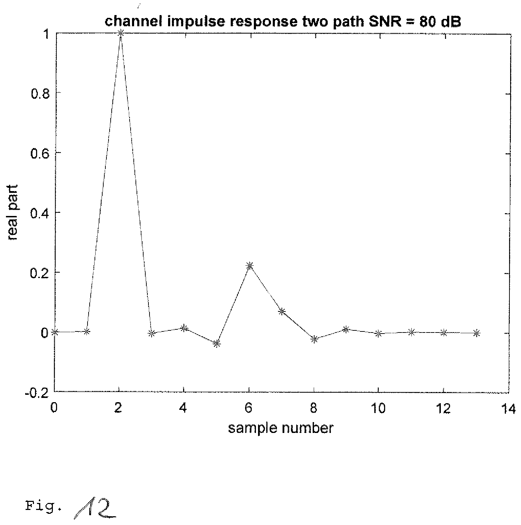

Fig. 12 illustrates a channel impulse response h of a multi-path transmission channel having two paths and a high signal-to-noise ratio SNR. In this case, the metric indicates that a calculation of a pre-distortion characteristic is not feasible. For calculation of the metric, the power of the main maximum and the power of the subordinate maxima can be determined and the ratio between these entities can be calculated. If this ratio is beneath a predefined threshold, a calculation of the pre-distortion characteristic is not performed.

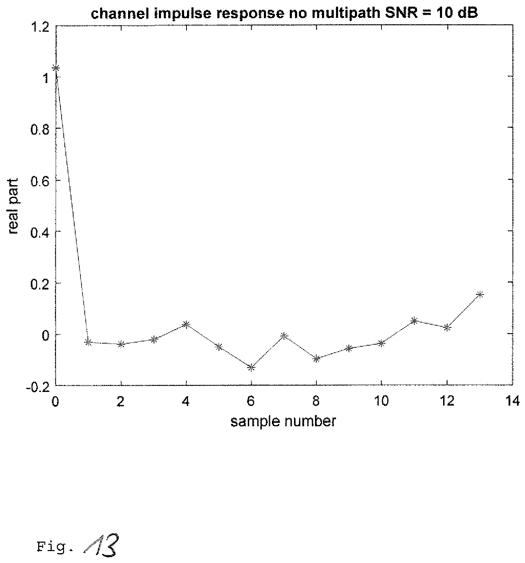

Fig. 13 illustrates a channel impulse response h of a transmission channel without multi-path signal propagation and a low signal-to-noise ratio SNR of 10 dB.

In a possible embodiment, the channel impulse response h can be calculated by a training sequence or test signal according to the minimum least square principle.

A received signal y can be formulated as follows:

$$y = A \cdot h + w \tag{1}$$

wherein y is the received signal vector of length N,
w is the noise signal vector of length N,
h is the channel impulse response vector of length L and
A is the matrix of complex training sequence symbols with size N x L.

The minimum least square solution is as follows:

$$\hat{h} = avg\ \min_{\hat{h}} \sum_{k=0}^{N-1} | y(k) - \sum_{i=0}^{L-1} \hat{h}(i) \cdot a\,(k-i)\ |^2 \tag{2}$$

$$\hat{h}(A^H A)^{-1}\, A^H y \tag{3}$$

wherein a training sequence can be chosen in such a way that it fulfills the condition:

$$A^H A = N \cdot I_L \tag{4}$$

In this case, the calculation of the channel impulse response h is simplified to the following matrix multiplication:

$$\hat{h} = A^H \cdot y \tag{5}$$

The channel impulse response h of the test signal received by the receiver of another apparatus 1B of the wireless network is determined by multiplication of a vector y of the received test signal with a matrix A comprising complex symbols of the test signal. The channel impulse response h calculated by matrix multiplication can be evaluated to derive metrics M representing the quality of the received test signal. Only if the metrics M indicate that the test signal received by the receiver comprises a sufficient quality, the pre-distortion characteristic is calculated by the processor 4B on the receiving side on the basis of the distorted ramp signal of the received test signal and on the basis of the known linear ramp signal.

In a possible embodiment, the transmission of the retransmission signal in step S5 of the method according to the present invention can be performed by the transmitter 3B of the test signal receiving second apparatus 1B having received the test signal of the wireless network with a time delay. The time-delayed transmission of the retransmission signal by the transmitter 3B of the test signal receiving second apparatus 1B of the wireless network allows a calibration or recalibration of the wireless network under control of an access layer of the respective wireless network. After having received and recognized the retransmission signal as directed to or as belonging to the first apparatus 1A, the first apparatus 1A having previously sent or broadcasted the associated test signal can store in a possible embodiment the pre-distortion characteristic extracted from the received retransmission signal in a local data memory. The stored pre-distortion characteristic can be then be used for performing a linearization of the transmission amplifier within the transmitter 2A by means of a pre-distortion unit of the first apparatus 1A in step S6 of the method according to the present invention.

The test signal and the retransmission signal can comprise in a possible implementation radio frequency, RF, signals. These signals can be sent in different channels or frequency bands or can be sent in different time slots.

Fig. 2 shows a block diagram for illustrating a possible exemplary embodiment of an apparatus according to a further aspect of the present invention. Fig. 2 illustrates the interaction of two similar apparatus 1 performing the method for linearizing a transmission amplifier according to the first aspect of the present invention. Apparatus 1A and apparatus 1B communicate with each other via a bidirectional communication or transmission channel. Apparatus 1A comprises a transmitter 2A and a receiver 3A. In the illustrated embodiment of Fig. 2, the first apparatus 1A further comprises a processing unit 4A. Apparatus 1B comprises in the illustrated embodiment of Fig. 2 a transmitter 2B, a receiver 3B and a processing unit 4B. Apparatus 1A and 1B form part of a wireless network.

In the illustrated schematic diagram of Fig. 2, the transmitter 2A of apparatus 1A sends a test signal via the bidirectional transmission channel to the receiver 3B of the other apparatus 1B. The transmitted test signal comprises a preamble and a ramp signal. The receiver 3B of apparatus 1B is adapted to receive the test signal. A received test signal can be processed by a processing unit 4B of the apparatus 1B to identify the transmitter of the transmitted test signal, for instance on the basis of the processed preamble of the test signal or on the basis of another processed identifier included in the test signal.

In a further step, the processing unit 4B of the apparatus 1B calculates a pre-distortion characteristic of the transmission amplifier within the transmitter 2A of apparatus 1A on the basis of the distorted ramp signal within the received test signal taking into account the known ideal non-distorted ramp signal. In a possible embodiment the calculation of the pre-distortion characteristic is performed by the processing unit 4B of the apparatus 1B only if quality metrics M of the received test signal indicate a sufficient quality of the received test signal.

In a further step, the transmitter 2B of apparatus 1B sends a retransmission signal back to apparatus 1A through the bidirectional transmission channel. The receiver 3A of apparatus 1A is adapted to receive the retransmission signal from the transmitter 3B of apparatus 1B of the wireless network. The retransmission signal transmitted by the transmitter 3B of apparatus 1B to the receiver 3A of apparatus 1A can also comprise a preamble. The transmission signal transports the pre-distortion characteristic of the transmission amplifier within the transmitter 2A of the first apparatus 1A having been calculated by the processing unit 4B of the second apparatus 1B. The transported pre-distortion characteristic can be extracted and then stored in a possible implementation in a local data memory of the first apparatus 1A. The stored pre-distortion characteristic and can be used for linearizing the transmission amplifier of the transmitter 2A of the first apparatus 1A. The transmission amplifier of the transmitter 2A of the first apparatus 1A is linearized according to the pre-distortion characteristic being calculated by the processing unit 4B of the second apparatus 1B within the wireless network on the basis of the test signal transmitted by the transmitter 2A of the first apparatus 1A and having been transported back to the first apparatus 1A within the retransmission signal sent by the transmitter 3B of the second apparatus 1B to the receiver 3A of first apparatus 1A.

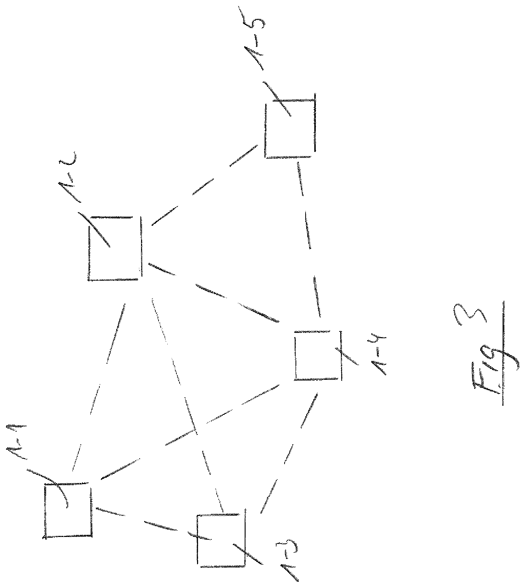

Apparatus 1A, 1B may form part of a wireless network comprising a plurality of similar apparatuses 1. In a possible embodiment, this wireless network may comprise a decentralized ad hoc network as also illustrated in Fig. 3. The wireless network illustrated in Fig. 3 can comprise a plurality of network nodes or apparatus 1 each having an integrated transmitter 2 and an integrated receiver 3. The nodes or devices within the wireless network shown in Fig. 3 are adapted to perform the method as illustrated in the flowchart of Fig. 1.

The apparatus 1 according to the present invention may also form part of other networks, in particular time-division multiplexing (TDM) networks or mobile telecommunication networks of different standards. In a possible embodiment, the apparatus 1 can also be integrated in a mobile device such as a vehicle.

The transmission of a test signal by an apparatus 1 can be triggered by the transmitting first apparatus 1A and/or by the receiving second apparatus 1B depending on the use case. A broadcasting of a test signal can also be performed in a test operation mode of an apparatus or a test operation mode of the whole wireless network, for instance after a setup of the wireless network. In a possible embodiment, the test signal may also be transmitted periodically for readjustment or calibration of the transmission amplifiers.

The method according to the present invention has the advantage that it does not need the provision of additional hardware within a circuit or a device forming a node within a wireless network. The method can be performed for all devices or nodes which operate in a wireless network with complex modulation bi-directionally. The nodes of the network communicate bi-directionally through a bidirectional transmission channel allowing to transmit and receive signals used to exchange data. Each node within the wireless network can trigger the calculation of a pre-distortion characteristic by broadcasting or sending a specific test signal. The signal received by an apparatus 1 or node within the wireless network can be recognized as a test signal by its preamble. The preamble of the test signal comprises two functions, i.e. it allows to recognize that a received signal forms a test signal and it can be used for performing an estimation of a quality of the transmission channel based on the channel impulse response h. The preamble may also comprise information allowing to identify the test signal transmitting node within the wireless network. In a possible embodiment, the wireless network may comprise different nodes such as illustrated in Figs. 2, 3 having similar resources. However, the method according to the present invention is not limited to such a use case. For instance, a test signal receiving apparatus 1B may not comprise sufficient processing resources to calculate a pre-distortion characteristic. In this case, the apparatus 1B may relay the received test signal to a third apparatus of the wireless network which comprises the necessary processing resources. A node or apparatus 1 within the wireless network comprises in a possible embodiment a transmitter 2, a receiver 3 and a processing unit 4 as shown in Fig.2. The apparatus 1 can further comprise a local data storage for storing a received distortion characteristic employed by a pre-distortion unit of the apparatus 1 to perform a pre-distortion of a signal supplied to a transmission amplifier of the transmitter 2 of the respective apparatus 1. The node or apparatus 1 can be integrated in a mobile device such as a vehicle. The generation of a test signal can be performed in specific operation mode or can be triggered event driven, e.g. if an observed signal distortion of a received signal exceeds a predetermined level.

In the illustrated embodiment of Fig. 2, each apparatus 1 within the wireless network comprises a transmitter 2, a receiver 3 and a processing unit 4. The apparatus 1 may comprise further entities such as sensors providing measurement data. After having successfully linearized the characteristic of the transmission amplifier of the transmitter 2 on the basis of the pre-distortion characteristic, the apparatus 1 may switch from a test operation mode to a normal operation mode where data is transmitted from one apparatus of the wireless network to another apparatus of the wireless network.

In a further possible application of the method according to the present invention, an additional pre-distortion against AM/PM distortion can be performed. This distortion is performed to compensate phase distortions within the transmitter characteristics. In this embodiment, a phase of the received ramp signal bw(k) is taken into account for calculation of the pre-distortion characteristic dw(k).

**Claims**

1.  A method for linearizing a transmission amplifier of a transmitter within a wireless network comprising the steps of:

    transmitting (S1) a test signal which comprises a preamble and a ramp signal by the transmitter of the wireless network,
    wherein the ramp signal of the test signal comprises a linear increasing ramp signal or a linear decreasing ramp signal and wherein the test signal transmitted by the transmitter of the wireless network comprises guard time intervals before (GTI1) and after (GTI2) the linear ramp signal included in the transmitted test signal to allow transmission filters and reception filters to swing in without influencing the linear ramp signal;
    receiving (S2) the test signal transmitted by the transmitter of the wireless network by at least one receiver of the wireless network;
    identifying (S3) the transmitter of the transmitted test signal by the at least one receiver of the wireless network on the basis of the preamble of the test signal received by the respective receiver of the wireless network;
    calculating (S4) a pre-distortion characteristic of the transmission amplifier of the identified transmitter by the at least one receiver of the wireless network on the basis of the distorted ramp signal of the test signal received by the receiver of the wireless network, wherein values, dw(k), of the pre-distortion characteristic are calculated by a processor connected to the receiver of the wireless network in response to values, aw(k), of a non-distorted linear ramp signal and depending on values, bw(k), of the distorted ramp signal within the test signal received by the receiver of the wireless network;
    transmitting (S5) a retransmission signal which comprises a preamble and the calculated pre-distortion characteristic of the transmission amplifier of the identified transmitter by the receiver of the wireless network to the identified transmitter of the wireless network, wherein the preamble of the retransmission signal identifies the respective signal as being a retransmission signal addressed to the apparatus comprising the identified transmitter; and
    linearizing (S6) the transmission amplifier of the transmitter on the basis of the pre-distortion characteristic of the retransmission signal received by the transmitter of the wireless network from the receiver of the wireless network.

2.  The method for linearizing a transmission amplifier of a transmitter within a wireless network according to claim 1 wherein if the receiver does not comprise sufficient resources to calculate the pre-distortion characteristic of the transmission amplifier of the transmitter the received test signal is relayed to a third apparatus of the wireless network.

3. The method for linearizing a transmission amplifier of a transmitter within a wireless network according to claim 1 wherein the preamble of the test signal comprises information used to identify the transmitter by the receiver and used for calculating a channel response, in particular a channel impulse response, h, of a transmission channel between the transmitter and the receiver of the wireless network.

4. The method for linearizing a transmission amplifier of a transmitter within a wireless network according to claims 1 to 3 wherein the preamble of the distorted ramp signal of the test signal received by the receiver of the wireless network is sampled with an oversampling rate.

5. The method for linearizing a transmission amplifier of a transmitter of a wireless network according to any of the preceding claims 1 to 4 wherein the preamble and the ramp signal of the transmitted test signal comprise complex signals.

6. The method for linearizing a transmission amplifier of a transmitter of a wireless network according to any of the preceding claims 1 to 5 wherein a phase of the received distorted ramp signal, bw(k), is taken into account for calculation of the pre-distortion characteristic, dw(k) used to compensate phase distortions within the transmitter characteristics of the transmitter.

7. The method for linearizing a transmission amplifier of a transmitter of a wireless network according to any of the preceding claims 1 to 6 wherein the linear increasing ramp signal of the transmitted test signal comprises a predefined number of symbols, k, comprising values between an initial value of zero and a final value of one divided by the square root of two (1/sqrt (2)).

8. The method for linearizing a transmission amplifier of a transmitter of a wireless network according to any of the preceding claims 1 to 7 wherein the values of the non-distorted linear ramp signal, aw(k), are read from a data memory of the receiver of the wireless network.

9. The method for linearizing a transmission amplifier of a transmitter of a wireless network according to any of the preceding claims 1 to 8 wherein the values, bw(k), of the distorted ramp signal of the test signal received by the receiver of the wireless network are normalized to a maximum value.

10. The method for linearizing a transmission amplifier of a transmitter of a wireless network according to any of the preceding claims 1 to 9 wherein for determining the values, dw(k), of the pre-distortion characteristic until a predefined threshold value, S, (k<=S) the values, dw(k), of the pre-distortion characteristic are set to a value of one (dw(k)=1), and wherein from the predefined threshold value, S, (k>S) on absolute values, abs(bw(k)), of the symbols, k, of the distorted ramp signal are divided by absolute values, abs(aw(k)), of the symbols, k, of the linear not distorted ramp signal to calculate the values, dw(k), of the pre-distortion characteristic.

11. The method for linearizing a transmission amplifier of a transmitter of a wireless network according to claim 10 wherein for linearizing the transmission amplifier each sample value, s(k), of a complex input signal supplied to the transmission amplifier of said transmitter are multiplied with a value, dw(n), of the pre-distortion characteristic, wherein the index, n, of the value of the pre-distortion characteristic used for multiplication is determined depending on the absolute value of the respective sample value, s(k), of the complex input signal supplied to the transmission amplifier and depending on a scaling factor, P.

12. The method for linearizing a transmission amplifier of a transmitter within a wireless network according to any of the preceding claims 1 to 11 wherein at least one metric, M, is determined which represents the quality of the test signal received by the receiver of the wireless network.

13. The method for linearizing a transmission amplifier of a transmitter of a wireless network according to claim 12 wherein the at least one metric, M, representing the quality of the received test signal is determined on the basis of a calculated channel response , in particular a channel impulse response, of the test signal received by the receiver of the wireless network.

14. The method for linearizing a transmission amplifier of a transmitter of a wireless network according to claim 12 or 13 wherein a first metric, M1, represents the quality of the test signal received by the receiver of the wireless network with respect to multi-path signal propagation and wherein a second metric, M2, represents the quality of the test signal received by the receiver of the wireless network with respect to a signal to noise ratio, SNR.

15. The method for linearizing a transmission amplifier of a transmitter of a wireless network according to claim 14 or wherein a multi-path signal propagation of the transmitted test signal is determined on the basis of spurious signal pulses within the test signal received by the receiver of the wireless network.

16. The method for linearizing a transmission amplifier of a transmitter of a wireless network according to claim 13 wherein the signal to noise ratio, SNR, of the test signal received by the receiver of the wireless network is determined by division of amplitudes of spurious signal pulses of the channel response of the received test signal by the amplitude of a main pulse of the channel response of the received test signal.

17. The method for linearizing a transmission amplifier of a transmitter of a wireless network according to claim 13 wherein the channel impulse response of the test signal received by the receiver of the wireless network is determined by multiplication of a vector of the received test signal with a matrix, A, comprising complex symbols of the test signal.

18. The method for linearizing a transmission amplifier of a transmitter of a wireless network according to any of the preceding claims 1 to 17 wherein the transmission of the retransmission signal is performed by the receiver of the wireless network with a time delay.

19. The method for linearizing a transmission amplifier of a transmitter of a wireless network according to claim 18 wherein by the time-delayed transmission of the retransmission signal by the receiver of the wireless network a calibration of the wireless network is performed under control of an access layer of the wireless network.

20. The method for linearizing a transmission amplifier of a transmitter of a wireless network according to any of the preceding claims 1 to 19 wherein the calculated pre-distortion characteristic included in the retransmission signal is stored in a data memory of the transmitter of the respective wireless network.

21. An apparatus (1A) for signal transmission within a wireless network comprising:

a transmitter (2A) adapted to transmit a transmission signal amplified by a transmission amplifier of the transmitter (2A) of the apparatus (1A) to a receiver (3B) of at least one other apparatus (1B) within the respective wireless network;

a receiver (3A) adapted to receive a retransmission signal from a transmitter (2B) of the other apparatus (1B) of the wireless network;

wherein the transmission amplifier of the transmitter (2A) of the apparatus (1A) is linearized according to a pre-distortion characteristic which is calculated by a processor (4B) of the other apparatus (1B) of the wireless network on the basis of a test signal transmitted by the transmitter (2A) of the apparatus (1A), wherein the calculated pre-distortion characteristic is transported within a retransmission signal received by the receiver (3A) of the respective apparatus (1A) from the transmitter (2B) the other apparatus (1B) of the wireless network.

**characterized in that**

the test signal transmitted by the transmitter (2A) of the apparatus (1A) comprises a preamble and a linear increasing ramp signal or a linear decreasing ramp signal, wherein the test signal transmitted by the transmitter (2A) of the apparatus (1A) comprises guard time intervals before (GTI1) and after (GTI2) the linear ramp signal included in the transmitted test signal to allow transmission filters and reception filters of the apparatus (1A) to swing in without influencing the linear ramp signal;

wherein the processor (4B) of the other apparatus (1B) is adapted to calculate the pre-distortion characteristic of the transmission amplifier of the transmitter (2A) on the basis of the distorted ramp signal of the test signal received by the receiver (1B) of the other apparatus (1B), wherein values, $dw(k)$, of the pre-distortion characteristic are calculated by the processor (4B) of the other apparatus (1B) in response to values, $aw(k)$, of a non-distorted linear ramp signal and depending on values, $bw(k)$, of the distorted ramp signal within the test signal received by the receiver (3B) of the other apparatus (1B);

wherein the transmitter (2A) of the transmitted test signal is identified on the basis of the preamble of the test signal received by the receiver (3B) of the other apparatus (1B) and wherein the retransmission signal is transmitted by the transmitter (2B) of the other apparatus (1B) to the receiver (3A) of the apparatus (1A) comprising the identified transmitter (2A), wherein the retransmission signal comprises a preamble and the calculated pre-distortion characteristic of the transmission amplifier of the identified transmitter (2A), wherein the preamble of the retransmission signal identifies the respective signal as being a retransmission signal addressed to the apparatus comprising the identified transmitter (2A).

22. A wireless network comprising a plurality of apparatuses (1) according to claim 21 adapted to exchange signals via a bidirectional transmission channel.

23. The wireless network according to claim 22 wherein the wireless network comprises a decentralized ad hoc network.

24. The wireless network according to claim 22 wherein the wireless network comprises a mobile telecommunication network.


**Patentansprüche**

1. Verfahren zum Linearisieren eines Sendeverstärkers eines Senders innerhalb eines drahtlosen Netzwerks, das die Schritte umfasst:

   Senden (S1) eines Testsignals, das eine Präambel und ein Rampensignal umfasst, durch den Sender des drahtlosen Netzwerks,
   wobei das Rampensignal des Testsignals ein lineares ansteigendes Rampensignal oder ein lineares abfallendes Rampensignal umfasst und wobei das durch den Sender des drahtlosen Netzwerks gesendete Testsignal Schutzzeitintervalle vor (GTI1) und nach (GTI2) dem in dem gesendeten Testsignal eingeschlossenen linearen Rampensignal umfasst, um Sendefiltern und Empfangsfiltern ein Einschwingen zu ermöglichen, ohne das lineare Rampensignal zu beeinflussen;
   Empfangen (S2) des durch den Sender des drahtlosen Netzwerks gesendeten Testsignals durch mindestens einen Empfänger des drahtlosen Netzwerks;
   Identifizieren (S3) des Senders des gesendeten Testsignals durch den mindestens einen Empfänger des drahtlosen Netzwerks auf der Basis der Präambel des durch den jeweiligen Empfänger des drahtlosen Netzwerks empfangenen Testsignals;
   Berechnen (S4) einer Vorverzerrungscharakteristik des Sendeverstärkers des identifizierten Senders durch den mindestens einen Empfänger des drahtlosen Netzwerks auf der Basis des verzerrten Rampensignals des durch den Empfänger des drahtlosen Netzwerks empfangenen Testsignals, wobei Werte, $dw(k)$, der Vorverzerrungscharakteristik durch einen mit dem Empfänger des drahtlosen Netzwerks verbundenen Prozessor als Reaktion auf Werte, $aw(k)$, eines unverzerrten linearen Rampensignals und abhängig von Werten, $bw(k)$, des verzerrten Rampensignals innerhalb des durch den Empfänger des drahtlosen Netzwerks empfangenen Testsignals berechnet werden;
   Senden (S5) eines Neusendesignals, das eine Präambel und die berechnete Vorverzerrungscharakteristik des Sendeverstärkers des identifizierten Senders umfasst, durch den Empfänger des drahtlosen Netzwerks an den identifizierten Sender des drahtlosen Netzwerks, wobei die Präambel des Neusendesignals das jeweilige Signal als Neusendesignal identifiziert, das an die Einrichtung adressiert ist, die den identifizierten Sender umfasst; und
   Linearisieren (S6) des Sendeverstärkers des Senders auf der Basis der Vorverzerrungscharakteristik des durch den Sender des drahtlosen Netzwerks von dem Empfänger des drahtlosen Netzwerks empfangenen Neusendesignals.

2. Verfahren zum Linearisieren eines Sendeverstärkers eines Senders innerhalb eines drahtlosen Netzwerks nach Anspruch 1, wobei, wenn der Empfänger keine ausreichenden Ressourcen zum Berechnen der Vorverzerrungscharakteristik des Sendeverstärkers des Senders umfasst, das empfangene Testsignal zu einer dritten Einrichtung des drahtlosen Netzwerks weitergeleitet wird.

3. Verfahren zum Linearisieren eines Sendeverstärkers eines Senders innerhalb eines drahtlosen Netzwerks nach Anspruch 1, wobei die Präambel des Testsignals Informationen umfasst, die zum Identifizieren des Senders durch den Empfänger verwendet werden und zum Berechnen einer Kanalantwort, insbesondere einer Kanalimpulsantwort, $h$, eines Sendekanals zwischen dem Sender und dem Empfänger des drahtlosen Netzwerks verwendet werden.

4. Verfahren zum Linearisieren eines Sendeverstärkers eines Senders innerhalb eines drahtlosen Netzwerks nach den Ansprüchen 1 bis 3, wobei die Präambel des verzerrten Rampensignals des durch den Empfänger des drahtlosen Netzwerks empfangenen Testsignals mit einer Oversampling-Rate abgetastet wird.

5. Verfahren zum Linearisieren eines Sendeverstärkers eines Senders eines drahtlosen Netzwerks nach einem der vorstehenden Ansprüche 1 bis 4, wobei die Präambel und das Rampensignal des gesendeten Testsignals komplexe Signale umfassen.

6. Verfahren zum Linearisieren eines Sendeverstärkers eines Senders eines drahtlosen Netzwerks nach einem der vorstehenden Ansprüche 1 bis 5, wobei eine Phase des empfangenen verzerrten Rampensignals, bw(k), zur Berechnung der Vorverzerrungscharakteristik, dw(k), berücksichtigt wird, die zum Kompensieren von Phasenverzerrungen innerhalb der Sendercharakteristik des Senders verwendet wird.

7. Verfahren zum Linearisieren eines Sendeverstärkers eines Senders eines drahtlosen Netzwerks nach einem der vorstehenden Ansprüche 1 bis 6, wobei das lineare ansteigende Rampensignal des gesendeten Testsignals eine vordefinierte Anzahl von Symbolen, k, umfasst, die Werte zwischen einem Anfangswert von null und einem Endwert von eins, dividiert durch die Quadratwurzel aus zwei (1/sqrt (2)), umfassen.

8. Verfahren zum Linearisieren eines Sendeverstärkers eines Senders eines drahtlosen Netzwerks nach einem der vorstehenden Ansprüche 1 bis 7, wobei die Werte des unverzerrten linearen Rampensignals, aw(k), aus einem Datenspeicher des Empfängers des drahtlosen Netzwerks gelesen werden.

9. Verfahren zum Linearisieren eines Sendeverstärkers eines Senders eines drahtlosen Netzwerks nach einem der vorstehenden Ansprüche 1 bis 8, wobei die Werte, bw(k), des verzerrten Rampensignals des durch den Empfänger des drahtlosen Netzwerks empfangenen Testsignals auf einen Maximalwert normiert werden.

10. Verfahren zum Linearisieren eines Sendeverstärkers eines Senders eines drahtlosen Netzwerks nach einem der vorstehenden Ansprüche 1 bis 9, wobei zum Ermitteln der Werte, dw(k), der Vorverzerrungscharakteristik bis zu einem vordefinierten Schwellenwert, S, (k <= S) die Werte, dw(k), der Vorverzerrungscharakteristik auf einen Wert von eins (dw(k) = 1) gesetzt werden und wobei ab dem vordefinierten Schwellenwert, S, (k > S) die Absolutwerte, abs(bw(k)), der Symbole, k, des verzerrten Rampensignals durch die Absolutwerte, abs(aw(k)), der Symbole, k, des linearen unverzerrten Rampensignals dividiert werden, um die Werte, dw(k), der Vorverzerrungscharakteristik zu berechnen.

11. Verfahren zum Linearisieren eines Sendeverstärkers eines Senders eines drahtlosen Netzwerks nach Anspruch 10, wobei zum Linearisieren des Sendeverstärkers jeder Abtastwert, s(k), eines dem Sendeverstärker des Senders zugeführten komplexen Eingangssignals mit einem Wert, dw(n), der Vorverzerrungscharakteristik multipliziert wird, wobei der Index, n, des zur Multiplikation verwendeten Werts der Vorverzerrungscharakteristik abhängig von dem Absolutwert des jeweiligen Abtastwerts, s(k), des dem Sendeverstärker zugeführten komplexen Eingangssignals und abhängig von einem Skalierungsfaktor, P, ermittelt wird.

12. Verfahren zum Linearisieren eines Sendeverstärkers eines Senders innerhalb eines drahtlosen Netzwerks nach einem der vorstehenden Ansprüche 1 bis 11, wobei mindestens eine Metrik, M, ermittelt wird, die die Qualität des durch den Empfänger des drahtlosen Netzwerks empfangenen Testsignals darstellt.

13. Verfahren zum Linearisieren eines Sendeverstärkers eines Senders eines drahtlosen Netzwerks nach Anspruch 12, wobei die mindestens eine Metrik, M, die die Qualität des empfangenen Testsignals darstellt, auf der Basis einer berechneten Kanalantwort, insbesondere einer Kanalimpulsantwort, des durch den Empfänger des drahtlosen Netzwerks empfangenen Testsignals ermittelt wird.

14. Verfahren zum Linearisieren eines Sendeverstärkers eines Senders eines drahtlosen Netzwerks nach Anspruch 12 oder 13, wobei eine erste Metrik, M1, die Qualität des durch den Empfänger des drahtlosen Netzwerks empfangenen Testsignals in Bezug auf eine Mehrweg-Signalausbreitung darstellt und wobei eine zweite Metrik, M2, die Qualität des durch den Empfänger des drahtlosen Netzwerks empfangenen Testsignals in Bezug auf ein Signal-Rausch-Verhältnis, SNR, darstellt.

15. Verfahren zum Linearisieren eines Sendeverstärkers eines Senders eines drahtlosen Netzwerks nach Anspruch 14 oder wobei eine Mehrweg-Signalausbreitung des gesendeten Testsignals auf der Basis von Störsignalimpulsen innerhalb des durch den Empfänger des drahtlosen Netzwerks empfangenen Testsignals ermittelt wird.

16. Verfahren zum Linearisieren eines Sendeverstärkers eines Senders eines drahtlosen Netzwerks nach Anspruch 13, wobei das Signal-Rausch-Verhältnis, SNR, des durch den Empfänger des drahtlosen Netzwerks empfangenen

EP 4 383 577 B1

Testsignals durch Division von Amplituden von Störsignalimpulsen der Kanalantwort des empfangenen Testsignals durch die Amplitude eines Hauptimpulses der Kanalantwort des empfangenen Testsignals ermittelt wird.

17. Verfahren zum Linearisieren eines Sendeverstärkers eines Senders eines drahtlosen Netzwerks nach Anspruch 13, wobei die Kanalimpulsantwort des durch den Empfänger des drahtlosen Netzwerks empfangenen Testsignals durch Multiplikation eines Vektors des empfangenen Testsignals mit einer Matrix, A, ermittelt wird, die komplexe Symbole des Testsignals umfasst.

18. Verfahren zum Linearisieren eines Sendeverstärkers eines Senders eines drahtlosen Netzwerks nach einem der vorstehenden Ansprüche 1 bis 17, wobei das Senden des Neusendesignals durch den Empfänger des drahtlosen Netzwerks mit einer Zeitverzögerung durchgeführt wird.

19. Verfahren zum Linearisieren eines Sendeverstärkers eines Senders eines drahtlosen Netzwerks nach Anspruch 18, wobei durch das zeitverzögerte Senden des Neusendesignals durch den Empfänger des drahtlosen Netzwerks eine Kalibrierung des drahtlosen Netzwerks unter Steuerung einer Zugriffsschicht des drahtlosen Netzwerks durchgeführt wird.

20. Verfahren zum Linearisieren eines Sendeverstärkers eines Senders eines drahtlosen Netzwerks nach einem der vorstehenden Ansprüche 1 bis 19, wobei die berechnete Vorverzerrungscharakteristik, die in dem Neusendesignal eingeschlossen ist, in einem Datenspeicher des Senders des jeweiligen drahtlosen Netzwerks gespeichert wird.

21. Einrichtung (1A) zum Signalsenden innerhalb eines drahtlosen Netzwerks, die umfasst:

einen Sender (2A), der geeignet ist, um ein durch einen Sendeverstärker des Senders (2A) der Einrichtung (1A) verstärktes Sendesignal zu einem Empfänger (3B) mindestens einer anderen Einrichtung (1B) innerhalb des jeweiligen drahtlosen Netzwerks zu senden;
einen Empfänger (3A), der geeignet ist, um ein Neusendesignal von einem Sender (2B) der anderen Einrichtung (1B) des drahtlosen Netzwerks zu empfangen;
wobei der Sendeverstärker des Senders (2A) der Einrichtung (1A) gemäß einer Vorverzerrungscharakteristik linearisiert wird, die durch einen Prozessor (4B) der anderen Einrichtung (1B) des drahtlosen Netzwerks auf der Basis eines durch den Sender (2A) der Einrichtung (1A) gesendeten Testsignals berechnet wird, wobei die berechnete Vorverzerrungscharakteristik innerhalb eines durch den Empfänger (3A) der jeweiligen Einrichtung (1A) von dem Sender (2B) der anderen Einrichtung (1B) des drahtlosen Netzwerks empfangenen Neusendesignal transportiert wird.
**dadurch gekennzeichnet, dass**
das durch den Sender (2A) der Einrichtung (1A) gesendete Testsignal eine Präambel und ein lineares ansteigendes Rampensignal oder ein lineares abfallendes Rampensignal umfasst, wobei das durch den Sender (2A) der Einrichtung (1A) gesendete Testsignal Schutzzeitintervalle vor (GTI1) und nach (GTI2) dem in dem gesendeten Testsignal eingeschlossenen linearen Rampensignal umfasst, um Sendefiltern und Empfangsfiltern der Einrichtung (1A) ein Einschwingen zu ermöglichen, ohne das lineare Rampensignal zu beeinflussen;
wobei der Prozessor (4B) der anderen Einrichtung (1B) geeignet ist, um die Vorverzerrungscharakteristik des Sendeverstärkers des Senders (2A) auf der Basis des verzerrten Rampensignals des durch den Empfänger (1B) der anderen Einrichtung (1B) empfangenen Testsignals zu berechnen, wobei Werte, dw(k), der Vorverzerrungscharakteristik durch den Prozessor (4B) der anderen Einrichtung (1B) als Reaktion auf Werte, aw(k), eines unverzerrten linearen Rampensignals und abhängig von Werten, bw(k), des verzerrten Rampensignals innerhalb des durch den Empfänger (3B) der anderen Einrichtung (1B) empfangenen Testsignals berechnet werden;
wobei der Sender (2A) des gesendeten Testsignals auf der Basis der Präambel des durch den Empfänger (3B) der anderen Einrichtung (1B) empfangenen Testsignals identifiziert wird und wobei das Neusendesignal durch den Sender (2B) der anderen Einrichtung (1B) an den Empfänger (3A) der Einrichtung (1A) gesendet wird, die den identifizierten Sender (2A) umfasst, wobei das Neusendesignal eine Präambel und die berechnete Vorverzerrungscharakteristik des Sendeverstärkers des identifizierten Senders (2A) umfasst, wobei die Präambel des Neusendesignals das jeweilige Signal als ein Neusendesignal identifiziert, das an die Einrichtung adressiert ist, die den identifizierten Sender (2A) umfasst.

22. Drahtloses Netzwerk, das eine Vielzahl von Einrichtungen (1) nach Anspruch 21 umfasst, die zum Austauschen von Signalen über einen bidirektionalen Sendekanal geeignet sind.

23. Drahtloses Netzwerk nach Anspruch 22, wobei das drahtlose Netzwerk ein dezentralisiertes Ad-hoc-Netzwerk umfasst.

24. Drahtloses Netzwerk nach Anspruch 22, wobei das drahtlose Netzwerk ein Mobilfunktelekommunikationsnetz umfasst.

**Revendications**

1. Procédé de linéarisation d'un amplificateur de transmission d'un émetteur au sein d'un réseau sans fil, comprenant les étapes consistant à :

la transmission (S1) d'un signal d'essai qui comprend un préambule et un signal de rampe par l'émetteur du réseau sans fil,
dans lequel le signal de rampe du signal d'essai comprend un signal de rampe linéaire croissant ou un signal de rampe linéaire décroissant et dans lequel le signal d'essai transmis par l'émetteur du réseau sans fil comprend des intervalles de temps de garde avant (GTI1) et après (GTI2) le signal de rampe linéaire inclus dans le signal d'essai transmis pour permettre à des filtres de transmission et à des filtres de réception d'osciller sans influencer le signal de rampe linéaire ;
la réception (S2) du signal d'essai transmis par l'émetteur du réseau sans fil par au moins un récepteur du réseau sans fil ;
l'identification (S3) de l'émetteur du signal d'essai transmis par l'au moins un récepteur du réseau sans fil sur la base du préambule du signal d'essai reçu par le récepteur respectif du réseau sans fil ;
le calcul (S4) d'une caractéristique de pré-distorsion de l'amplificateur de transmission de l'émetteur identifié par l'au moins un récepteur du réseau sans fil sur la base du signal de rampe distordu du signal d'essai reçu par le récepteur du réseau sans fil, dans lequel les valeurs, dw(k), de la caractéristique de pré-distorsion sont calculées par un processeur connecté au récepteur du réseau sans fil en réponse à des valeurs, aw(k), d'un signal de rampe linéaire non distordu et en fonction de valeurs, bw(k), du signal de rampe distordu dans le signal d'essai reçu par le récepteur du réseau sans fil ;
la transmission (S5) d'un signal de retransmission qui comprend un préambule et la caractéristique de pré-distorsion calculée de l'amplificateur de transmission de l'émetteur identifié par le récepteur du réseau sans fil à l'émetteur identifié du réseau sans fil, dans lequel le préambule du signal de retransmission identifie le signal respectif comme étant un signal de retransmission adressé à l'appareil comprenant l'émetteur identifié ; et
la linéarisation (S6) de l'amplificateur de transmission de l'émetteur sur la base de la caractéristique de pré-distorsion du signal de retransmission reçu par l'émetteur du réseau sans fil à partir du récepteur du réseau sans fil.

2. Procédé de linéarisation d'un amplificateur de transmission d'un émetteur au sein d'un réseau sans fil selon la revendication 1, dans lequel, si le récepteur ne dispose pas de ressources suffisantes pour calculer la caractéristique de pré-distorsion de l'amplificateur de transmission de l'émetteur, le signal d'essai reçu est relayé à un troisième appareil du réseau sans fil.

3. Procédé de linéarisation d'un amplificateur de transmission d'un émetteur au sein d'un réseau sans fil selon la revendication 1, dans lequel le préambule du signal d'essai comprend des informations utilisées pour identifier l'émetteur par le récepteur et utilisées pour calculer une réponse de canal, en particulier une réponse impulsionnelle de canal, h, d'un canal de transmission entre l'émetteur et le récepteur du réseau sans fil.

4. Procédé de linéarisation d'un amplificateur de transmission d'un émetteur au sein d'un réseau sans fil selon les revendications 1 à 3, dans lequel le préambule du signal de rampe distordu du signal d'essai reçu par le récepteur du réseau sans fil est échantillonné avec un taux de suréchantillonnage.

5. Procédé de linéarisation d'un amplificateur de transmission d'un émetteur d'un réseau sans fil selon l'une quelconque des revendications précédentes 1 à 4, dans lequel le préambule et le signal de rampe du signal d'essai transmis comprennent des signaux complexes.

6. Procédé de linéarisation d'un amplificateur de transmission d'un émetteur d'un réseau sans fil selon l'une quelconque des revendications précédentes 1 à 5, dans lequel une phase du signal de rampe distordu reçu, bw(k), est prise en compte pour le calcul de la caractéristique de pré-distorsion, dw(k), utilisée pour compenser des distorsions de phase dans les caractéristiques d'émission de l'émetteur.

7. Procédé de linéarisation d'un amplificateur de transmission d'un émetteur d'un réseau sans fil selon l'une quelconque des revendications précédentes 1 à 6, dans lequel le signal de rampe linéaire croissant du signal d'essai transmis comprend un nombre prédéfini de symboles, k, comprenant des valeurs comprises entre une valeur initiale de zéro et une valeur finale de un divisé par la racine carrée de deux (1/sqrt (2)).

8. Procédé de linéarisation d'un amplificateur de transmission d'un émetteur d'un réseau sans fil selon l'une quelconque des revendications précédentes 1 à 7, dans lequel les valeurs du signal de rampe linéaire non distordu, aw(k), sont lues à partir d'une mémoire de données du récepteur du réseau sans fil.

9. Procédé de linéarisation d'un amplificateur de transmission d'un émetteur d'un réseau sans fil selon l'une quelconque des revendications précédentes 1 à 8, dans lequel les valeurs, bw(k), du signal de rampe distordu du signal d'essai reçu par le récepteur du réseau sans fil sont normalisées à une valeur maximale.

10. Procédé de linéarisation d'un amplificateur de transmission d'un émetteur d'un réseau sans fil selon l'une quelconque des revendications précédentes 1 à 9 dans lequel, pour déterminer les valeurs, dw(k), de la caractéristique de pré-distorsion jusqu'à une valeur seuil prédéfinie, S, (k<=S), les valeurs, dw(k), de la caractéristique de pré-distorsion sont fixées à une valeur de un (dw(k)=1), et dans lequel, à partir de la valeur seuil prédéfinie, S, (k>S), sur des valeurs absolues, abs(bw(k)), des symboles, k, du signal de rampe distordu sont divisées par des valeurs absolues, abs(aw(k)), des symboles, k, du signal de rampe linéaire non distordu afin de calculer les valeurs, dw(k), de la caractéristique de pré-distorsion.

11. Procédé de linéarisation d'un amplificateur de transmission d'un émetteur d'un réseau sans fil selon la revendication 10, dans lequel, pour linéariser l'amplificateur de transmission, chaque valeur d'échantillon, s(k), d'un signal d'entrée complexe fourni à l'amplificateur de transmission dudit émetteur est multipliée par une valeur, dw(n), de la caractéristique de pré-distorsion, dans lequel l'indice, n, de la valeur de la caractéristique de pré-distorsion utilisée pour la multiplication est déterminé en fonction de la valeur absolue de la valeur d'échantillon respective, s(k), du signal d'entrée complexe fourni à l'amplificateur de transmission et en fonction d'un facteur de mise à l'échelle, P.

12. Procédé de linéarisation d'un amplificateur de transmission d'un émetteur au sein d'un réseau sans fil selon l'une quelconque des revendications précédentes 1 à 11, dans lequel on détermine au moins une métrique, M, qui représente la qualité du signal d'essai reçu par le récepteur du réseau sans fil.

13. Procédé de linéarisation d'un amplificateur de transmission d'un émetteur d'un réseau sans fil selon la revendication 12, dans lequel l'au moins une métrique, M, représentant la qualité du signal d'essai reçu est déterminée sur la base d'une réponse de canal calculée, en particulier une réponse impulsionnelle de canal, du signal d'essai reçu par le récepteur du réseau sans fil.

14. Procédé de linéarisation d'un amplificateur de transmission d'un émetteur d'un réseau sans fil selon la revendication 12 ou 13, dans lequel une première métrique, M1, représente la qualité du signal d'essai reçu par le récepteur du réseau sans fil par rapport à la propagation du signal par trajets multiples et dans lequel une seconde métrique, M2, représente la qualité du signal d'essai reçu par le récepteur du réseau sans fil par rapport à un rapport signal/bruit, SNR.

15. Procédé de linéarisation d'un amplificateur de transmission d'un émetteur d'un réseau sans fil selon la revendication 14 ou dans lequel une propagation du signal par trajets multiples du signal d'essai transmis est déterminée sur la base d'impulsions de signal parasites dans le signal d'essai reçu par le récepteur du réseau sans fil.

16. Procédé de linéarisation d'un amplificateur de transmission d'un émetteur d'un réseau sans fil selon la revendication 13, dans lequel le rapport signal/bruit, SNR, du signal d'essai reçu par le récepteur du réseau sans fil est déterminé par la division d'amplitudes d'impulsions de signal parasites de la réponse de canal du signal d'essai reçu par l'amplitude d'une impulsion principale de la réponse de canal du signal d'essai reçu.

17. Procédé de linéarisation d'un amplificateur de transmission d'un émetteur d'un réseau sans fil selon la revendication 13, dans lequel la réponse impulsionnelle de canal du signal d'essai reçu par le récepteur du réseau sans fil est déterminée par la multiplication d'un vecteur du signal d'essai reçu avec une matrice, A, comprenant des symboles complexes du signal d'essai.

18. Procédé de linéarisation d'un amplificateur de transmission d'un émetteur d'un réseau sans fil selon l'une quelconque

14

des revendications précédentes 1 à 17, dans lequel la transmission du signal de retransmission est effectuée par le récepteur du réseau sans fil avec un temps de retard.

19. Procédé de linéarisation d'un amplificateur de transmission d'un émetteur d'un réseau sans fil selon la revendication 18, dans lequel, par la transmission retardée du signal de retransmission par le récepteur du réseau sans fil, un étalonnage du réseau sans fil est effectué sous le contrôle d'une couche d'accès du réseau sans fil.

20. Procédé de linéarisation d'un amplificateur de transmission d'un émetteur d'un réseau sans fil selon l'une quelconque des revendications précédentes 1 à 19, dans lequel la caractéristique de pré-distorsion calculée incluse dans le signal de retransmission est stockée dans une mémoire de données de l'émetteur du réseau sans fil respectif.

21. Appareil (1A) pour la transmission de signaux au sein d'un réseau sans fil comprenant :

   un émetteur (2A) destiné à transmettre un signal de transmission amplifié par un amplificateur de transmission de l'émetteur (2A) de l'appareil (1A) à un récepteur (3B) d'au moins un autre appareil (1B) au sein du réseau sans fil respectif ;
   un récepteur (3A) destiné à recevoir un signal de retransmission à partir d'un émetteur (2B) de l'autre appareil (1B) du réseau sans fil ;
   dans lequel l'amplificateur de transmission de l'émetteur (2A) de l'appareil (1A) est linéarisé selon une caractéristique de pré-distorsion qui est calculée par un processeur (4B) de l'autre appareil (1B) du réseau sans fil sur la base d'un signal d'essai transmis par l'émetteur (2A) de l'appareil (1A), dans lequel la caractéristique de pré-distorsion calculée est transportée dans un signal de retransmission reçu par le récepteur (3A) de l'appareil (1A) respectif à partir de l'émetteur (2B) de l'autre appareil (1B) du réseau sans fil.
   **caractérisé en ce que**
   le signal d'essai transmis par l'émetteur (2A) de l'appareil (1A) comprend un préambule et un signal de rampe linéaire croissant ou un signal de rampe linéaire décroissant, dans lequel le signal d'essai transmis par l'émetteur (2A) de l'appareil (1A) comprend des intervalles de temps de garde avant (GTI1) et après (GTI2) le signal de rampe linéaire inclus dans le signal d'essai transmis pour permettre à des filtres de transmission et à des filtres de réception de l'appareil (1A) d'osciller sans influencer le signal de rampe linéaire ;
   dans lequel le processeur (4B) de l'autre appareil (1B) est destiné à calculer la caractéristique de pré-distorsion de l'amplificateur de transmission de l'émetteur (2A) sur la base du signal de rampe distordu du signal d'essai reçu par le récepteur (1B) de l'autre appareil (1B), dans lequel des valeurs, dw(k), de la caractéristique de pré-distorsion sont calculées par le processeur (4B) de l'autre appareil (1B) en réponse aux valeurs, aw(k), d'un signal de rampe linéaire non distordu et en fonction de valeurs, bw(k), du signal de rampe distordu dans le signal d'essai reçu par le récepteur (3B) de l'autre appareil (1B) ;
   dans lequel l'émetteur (2A) du signal d'essai transmis est identifié sur la base du préambule du signal d'essai reçu par le récepteur (3B) de l'autre appareil (1B) et dans lequel le signal de retransmission est transmis par l'émetteur (2B) de l'autre appareil (1B) au récepteur (3A) de l'appareil (1A) comprenant l'émetteur identifié (2A), dans lequel le signal de retransmission comprend un préambule et la caractéristique de pré-distorsion calculée de l'amplificateur de transmission de l'émetteur identifié (2A), dans lequel le préambule du signal de retransmission identifie le signal respectif comme étant un signal de retransmission adressé à l'appareil comprenant l'émetteur identifié (2A).

22. Réseau sans fil comprenant une pluralité d'appareils (1) selon la revendication 21, destinés à échanger des signaux par le biais d'un canal de transmission bidirectionnel.

23. Réseau sans fil selon la revendication 22, dans lequel le réseau sans fil comprend un réseau ad hoc décentralisé.

24. Réseau sans fil selon la revendication 22, dans lequel le réseau sans fil comprend un réseau de télécommunication mobile.

Fig 1

Fig 2

Fig 3

Fig. 4

imaginary part of *test signal*

Fig. 5

Fig. 6

real part of linearization hop with root-nyquist pulse shaping

RAMP SIGNAL

Fig. 7

Fig. 8

**power spectrum of data hop**

Fig. 9

Fig. 10

channel impulse response no multipath SNR = 80 dB

Fig. 11

channel impulse response two path SNR = 80 dB

Fig. 12

channel impulse response no multipath SNR = 10 dB

Fig. 13

**EP 4 383 577 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007044957 A

- WO 2017030935 A